# EUROPÄISCHE PATENTSCHRIFT

(11) **EP 2 036 202 B1**
(45) Veröffentlichungstag und Bekanntmachung des Hinweises auf die Patenterteilung: **13.06.2018**
(21) Anmeldenummer: 07764721.2
(22) Anmeldetag: 20.06.2007
(51) Int. Cl.: H03K 17/16, H02M 7/5387, H03K 17/687

(54) **SCHALTUNGSANORDNUNG UND VERFAHREN ZUM ANSTEUERN EINES ELEKTRISCHEN VERBRAUCHERS**
CIRCUIT ARRANGEMENT AND METHOD FOR CONTROLLING AN ELECTRICAL CONSUMER
CIRCUITERIE ET PROCEDE DESTINES A LA COMMANDE D'UN CONSOMMATEUR ELECTRIQUE

(30) Priorität: 30.06.2006 DE 102006030821
(43) Veröffentlichungstag der Anmeldung: 18.03.2009
(73) Patentinhaber: Braun GmbH, 61476 Kronberg im Taunus (DE)
(72) Erfinder: KLEMM, Torsten, 65812 Bad Soden (DE); VETTER, Ingo, 61184 Karben (DE)
(74) Vertreter: Zetterer, Gerd
(86) Internationale Anmeldenummer: PCT/EP2007/005396
(87) Internationale Veröffentlichungsnummer: WO 2008/000373

(56) Entgegenhaltungen:
- WO-A-95/24076
- DE-A1- 10 206 392
- FR-A- 2 847 354
- US-B1- 7 019 551
- "CMOS DELAY CONTROLLED CIRCUIT" IBM TECHNICAL DISCLOSURE BULLETIN, IBM CORP. NEW YORK, US, Bd. 38, Nr. 3, 1. März 1995 (1995-03-01), Seiten 279-280, XP000508053 ISSN: 0018-8689

## Beschreibung

Die Erfindung betrifft eine Schaltungsanordnung gemäß dem Oberbegriff des Anspruchs 1 und ein Verfahren zum Ansteuern eines elektrischen Verbrauchers gemäß dem Oberbegriff des Anspruch 8, mit der ein Elektromotor eines batteriebetriebenen Elektrokleingeräts betrieben wird.

Eine derartige Schaltungsanordnung ist in der DE 10 2005 059 571 beschrieben. Aus der DE 102 46 520 A1 ist ferner eine Schaltungsanordnung und ein Verfahren zum Ansteuern eines oszillierenden Elektromotors eines batteriebetriebenen Elektrokleingeräts mittels einer Brückenschaltung bekannt. Wird das Elektrokleingerät beispielsweise mit einem Li-Ionen-Akkumulator betrieben, und werden die elektronischen Schalter der Brückenschaltung durch eine Steuerschaltung entweder mit einem "Low"-Pegel oder einem "High"-Pegel angesteuert, kann beim Umschalten der elektronischen Schalter die Versorgungsspannung stark einbrechen oder sich sogar mehr als verdoppeln, da ein Li-Ionen-Akkumulator eine im Vergleich zu anderen Akkumulatoren große parasitäre Induktivität besitzt, die bei Stromänderungen eine entsprechend große Gegenspannung induziert.

In der FR 2 847 354 B1 wird eine Pufferschaltung mit zwei Transistoren zum Schalten einer Last mit zwei Referenzspannungen beschrieben, die zwei binäre Werte in Abhängigkeit von einem Eingangsdatensignal repräsentieren. Jeder der beiden Ausgangstransistoren wird durch ein Steuersignal mit wenigstens zwei Abschnitten angetrieben. In einem vorläufigen Abschnitt werden die Transistoren mit einer Spannung unterhalb des Absolutwerts der jeweiligen Referenzspannungen, an die sie angeschlossen sind, angetrieben. Während des zweiten Teils des Antriebssignals werden die Transistoren mit Spannungen gleich ihren Bezugsspannungen angetrieben.

Die DE 102 06 392 A1 offenbart Verfahren zur Optimierung des Abschaltvorgangs eines abschaltbaren Leistungs-Halbleiterschalters, wobei mit Eintreffen eines Ausschaltsignals die Gate-Emitterspannung diesesLeistungs-Halbleiterschalters zweistufig abgesenkt wird, indem die Gate-Emitterspannung zunächst in einem ersten Schritt auf eine Höhe abgesenkt wird, die eine um einen vorgegebenen Wert erhöhte Durchlassspannung der Kollektor-Emitter-Strecke des Leistungs-Halbleiterschalters bewirkt, ehe die Gate-Emitterspannung in einem zweiten Schritt auf einen endgültigen Abschaltwert abgesenkt wird.

Aus der WO 95/24076 A1 ist eine anstiegsgeschwindigkeit-gesteuerte Schaltanordnung mit einem Transistor mit einer an eine Stromversorgung gekoppelten Source, mit einem mit einem ersten Anschluss mit der Source des Transistors gekoppelten Pull-up-Widerstand, mit einem mit einem ersten Anschluß mit dem Gate des Transistors und mit einem zweiten Anschluss mit dem Pull-up-Widerstand verbunden Gate-Widerstand und mit einem mit einem ersten Anschluss mit dem Gate-Widerstand und einem zweiten Anschluss mit dem Drain des Transistors gekoppelten Rückkopplungskondensator beschrieben. Wenn der Eingang von einem hohen Wert auf einen niedrigen Wert umgeschaltet wird, steigt die Drainspannung leicht und nahezu linear von einem niedrigen Wert auf einen hohen Wert, und zwar mit einer Rate proportional zu dem Produkt aus dem Wert des Gatewiderstands und dem Wert einer Kapazität zwischen dem Gate und dem Drain.

Aus der US 7,019,551 B1 ist ein Ausgangspuffer mit einer gesteuerten Ausgangsanstiegsrate bekannt, der eine erste Vortreiber-Schaltung mit einer ersten RC-Schaltung und einem ersten Ausgangsknoten und eine zweite Vortreiberschaltung mit einer zweiter RC-Schaltung und einen zweiten Ausgangsknoten aufweist. Die Zeitkonstanten der RC-Schaltungen steuern eine Signalanstiegsgeschwindigkeit an einem dritten Ausgangsknoten der Ausgangsschaltung, wobei der Wert des Widerstands gewählt werden kann, um eine vorbestimmte kontrollierte Anstiegsgeschwindigkeitsbereich bei dem dritten Ausgangsknoten bereitzustellen.

In der Veröffentlichung IBM Technical Disclosure Bulletin, IBM Corp. New York, Vol. 38 no. 3, Seiten 279 bis 280, wird ein Schaltkreis beschrieben, bei dem eine CMOS-Verzögerung bei der Steuerung verwendet wird,

Es ist Aufgabe der vorliegenden Erfindung eine Schaltungsanordnung und ein Verfahren zum Ansteuern eines elektrischen Verbrauchers anzugeben, die/das speziell für den Betrieb an einer Spannungsquelle mit großer parasitärer Induktivität ausgelegt ist.

Erfindungsgemäß ist diese Aufgabe durch eine Schaltungsanordnung gelöst, die mindestens einen elektronischen Schalter und eine Steuerschaltung aufweist, die den elektronischen Schalters so vom nichtleitenden Zustand in den leitenden Zustand umschaltet und/oder umgekehrt, daß die zeitlichen Änderungen des fließenden Stroms relativ klein sind. Auf diese Weise kann die relativ große parasitäre Induktivität eines zur Stromversorgung verwendeten Li-Ionen-Akkumulators keine allzugroßen Gegenspannungen erzeugen, sodaß beispielsweise ein als Steuerschaltung verwendeter Mikrokontroller unmittelbar vom Akkumulator mit Strom versorgt werden kann, d.h. beispielsweise auf Kondensatoren zur Glättung der Spannung des Akkumulators verzichtet werden kann. Die Schaltungsanordnung ist vorzugsweise für elektrische Zahnbürsten oder elektrische Rasierapparate gedacht, die als Antrieb einen oszillierenden Elektromotor oder Linearmotor aufweisen und mit einem Li-Ionen-Akkumulator betrieben werden, und zeichnet sich durch geringen schaltungstechnischen Aufwand aus.

Große zeitliche Änderungen des fließenden Stroms können jedoch nicht nur wegen der relativ großen parasitären Induktivität eines zur Stromversorgung verwendeten Li-Ionen-Akkumulators unerwünscht große Gegenspannungen erzeugen sondern natürlich auch wegen der Induktivität des durch die Schaltungsanordnung gesteuerten elektrischen Verbrauchers. Stellt der Verbraucher eine induktive Last dar, wird das erfindungsgemäße Verfahren zumindest beim Ausschalten des durch den Verbraucher fließenden Stroms angewendet.

Beim erfindungsgemäßen Verfahren zum Ansteuern eines elektrischen Verbrauchers wird die zuvor beschriebene Schaltungsanordnung vorgesehen. Die Steuerschaltung schaltet den/die elektronischen Schalter in mindestens zwei Schritten vom leitenden Zustand in den nicht leitenden Zustand und/oder umgekehrt, beispielsweise wird der Pegel am Steueranschluß der Steuerschaltung bzw. am Steueranschluß des elektronischen Schalters von "Low" über "Offen" auf "High" bzw. von "High" über "Offen" auf "Low" geschaltet. Das erfindungsgemäße Verfahren läßt sich bei einer Steuerschaltung in CMOS-Technik vorzugsweise dadurch realisieren, daß der Steueranschluß der Steuerschal- tung entweder als Eingang ("high impedance") oder als Ausgang ("Low" oder "High") geschaltet werden kann ("tristate"), und zum Umschalten des elektronischen Schalters vom leitenden Zustand in den nicht leitenden Zustand und/oder umgekehrt der Steueranschluß des elektronischen Schalters von "Low" über "high impedance" auf "High" bzw. von "High" über "high impedance" auf "Low" umgeschaltet wird. Vorzugsweise führt die Steuerschaltung den zweiten Schritt, d.h. das Umschalten von "high impedance" auf "High" oder "Low", erst dann durch, nachdem der elektronische Schalter seinen Zustand ("leitend" bzw. "nicht leitend") geändert hat.

Bei einer erfindungsgemäßen Schaltungsanordnung, bei der die Steuerschaltung den elektrischen Verbraucher durch vier elektronische Schalter in Brückenschaltung ansteuert, und der Verbraucher im Querzweig der Brückenschaltung angeordnet ist, weist die Steuerschaltung Steueranschlüsse für die vier elektronischen Schalter auf. Erfindungsgemäß ist der Steueranschluß für den ersten elektronischen Schalter über eine Reihenschaltung aus einem ersten Kondensator und einem ersten Widerstand mit dem Steueranschluß für den vierten elektronischen Schalter verbunden, und der Steueranschluß für den dritten elektronischen Schalter ist über eine Reihenschaltung aus einem zweiten Kondensator und einem zweiten Widerstand mit dem Steueranschluß für den zweiten elektronischen Schalter verbunden. Der erste und vierte elektronische Schalter sind mit dem einen Ende des elektrischen Verbrauchers verbunden, und der zweite und dritte elektronische Schalter sind mit dem anderen Ende des elektrischen Verbrauchers verbunden.

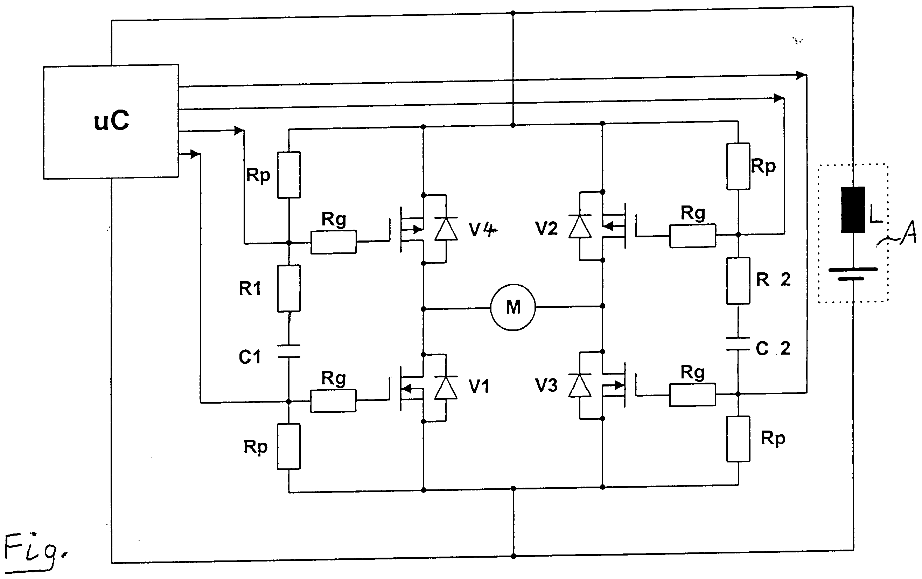

Die Erfindung wird nachstehend anhand eines Ausführungsbeispiels für eine erfindungsgemäße Schaltungsanordnung zum Ansteuern eines elektrischen Verbrauchers erläutert, die in der einzigen Zeichnung dargestellt ist. Weitere Ausgestaltungen sind in der Beschreibung besch rieben.

Die in der Figur dargestellte erfindungsgemäße Schaltungsanordnung enthält einen Akkumulator A, der eine parasitäre Induktivität L aufweist. Ferner ist eine Brückenschaltung vorhanden, die vier Transistoren V1, V2, V3, V4 aufweist, und in deren Querzweig ein Elektromotor M oder ein anderer elektrischer Verbraucher angeordnet ist. Die vier Transistoren V1, V2, V3, V4 sind MOS-FETs, die in an sich bekannter Weise je eine Schutzdiode aufweisen. Sie können von einer Steuerschaltung uC gesteuert werden, die zu diesem Zweck vier Steueranschlüsse aufweist, von denen jeder die Zustände "high impedance" (Eingang) oder "Low" oder "High" (Ausgang) annehmen kann ("tristate"). Die Steuerschaltung uC wird direkt vom Akkumulator A mit Strom versorgt. Der erste V1 und dritte Transistor V3 sind n-Kanal-MOS-FETs, deren Source-Anschlüsse mit dem Minuspol des Akkumulators A verbunden sind; der zweite V2 und vierte Transistor V4 sind p-Kanal-MOS-FETs, deren Source-Anschlüsse mit dem Pluspol des Akkumulators A verbunden sind. Die Drain-Anschlüsse des ersten V1 und vierten MOS-FETs V4 sind mit dem einen Ende des Motors M verbunden, und die Drain-Anschlüsse des zweiten V2 und dritten MOS-FETs V3 sind mit dem anderen Ende des Motors M verbunden. Die Gate-Anschlüsse der vier Transistoren V1, V2, V3, V4 sind über je einen Gate-Widerstand Rg mit je einem der vier Steueranschlüsse der Steuerschaltung uC verbunden. Die Gate-Widerstände Rg dienen zum Begrenzen des Gesamtstroms, der beim Ansteuern der Transistoren in die Steuereinrichtung fließt. Sie können auch weggelassen sein, wenn die Steuerschaltung für entsprechend höhere Ströme ausgelegt ist. Die Source-Anschlüsse eines jeden Transistors sind über je einen Pull-up/Pull-down-Widerstand Rp und den zugehörigen Gate-Widerstand Rg mit dem Gate-Anschluß des jeweiligen Transistors verbunden. Der Steueranschluß für den ersten Transistor V1 ist über eine Reihenschaltung aus einem ersten Widerstand R1 und einem ersten Kondensator C1 mit dem Steueranschluß für den vierten Transistor V4 verbunden. Der Steueranschluß für den dritten Transistor V3 ist über eine Reihenschaltung aus einem zweiten Widerstand R2 und einem zweiten Kondensator C2 mit dem Steueranschluß für den zweiten Transistor V2 verbunden.

Die Funktionsweise der in der Figur dargestellten Schaltungsanordnung wird nachstehend beschrieben. In der zunächst betrachteten Ausgangssituation befindet sich die Schaltungsanordnung in einem Zustand, in dem an den Steueranschlüssen für den vierten V4 und den ersten Transistor V1 ein "Low"-Potential herrscht, und an den Steueranschlüssen für den zweiten V2 und den dritten Transistor V3 ein "High"-Potential herrscht. Somit ist der vierte V4 und der dritte Transistor V3 durchgeschaltet, wogegen der erste V1 und der zweite Transistor V2 sperren, sodaß aus dem Akkumulator A über den vierten V4 und den dritten Transistor V3 ein Strom durch den Motor M fließt. Die Schaltungsanordnung soll nun in den Zustand umgeschaltet werden, in dem der Strom durch den Motor M in der umgekehrten Richtung, d.h. aus dem Akkumulator A über den zweiten V2 und den ersten Transistor V1 fließt. Dieses Umschalten, d.h. Abschalten des gerade fließenden Stroms und anschließendes Einschalten eines Stroms in umgekehrter Richtung, wird nachfolgend erläutert.

In der oben angegebenen Ausgangssituation herrscht an den Steueranschlüssen für den vierten V4 und den ersten Transistor V1 ein "Low"-Potential, sodaß der erste Kondensator C1 entladen ist. Das Abschalten des gerade fließenden Stroms beginnt nun damit, daß die Steuerschaltung uC zu einem Zeitpunkt T1 den Steueranschluß für den vierten Transistor V4 von "Low" auf "high impedance" umschaltet, wodurch die Spannung am Gate des vierten Transistors V4 auf einen durch das Verhältnis Rp/R1 bestimmten Wert springt. Dadurch liegt jetzt eine Spannung am Kondensator C1 an, durch die dieser aufgeladen wird. Gleichzeitig wird die Miller-Kapazität (parasitäre Gate-Drain-Kapazität) des vierten Transistors V4 entladen. Das Aufladen des Kondensators C1 bewirkt ein weiteres Ansteigen der Spannung am Gate des vierten Transistors V4, und somit ein weiters Entladen der Miller-Kapazität des vierten Transistors V4. Wenn die Gate-Source-Spannung zu einem Zeitpunkt T2 > T1 ungefähr denselben Wert erreicht hat wie die Drain-Source-Spannung geht der vierte Transistor V4 in seinen ausgeschalteten Zustand über, und die Miller-Kapazität fällt auf einen vergleichsweise kleinen Wert ab. Die Spannung am Gate des vierten Transistors V4 steigt daraufhin noch weiter an, wobei die Zeitkonstante dieser Spannungsänderung jetzt allerdings kaum noch von der Miller-Kapazität des vierten Transistors V4 sondern hauptsächlich von der Kapazität des ersten Kondensators C1 und der Summe Rp+R1 bestimmt ist. Zu einem Zeitpunkt T3 > T2 schaltet die Steuerschaltung uC den Steueranschluß für den vierten Transistor V4 von "high impedance" auf "High" um, wodurch das Abschalten des vierten Transistors V4 beendet wird. Bei geeigneter Dimensionierung des ersten Kondensators C1 und der Widerstände Rp und Rg und geeigneter Wahl des Schaltzeitpunkts T3 in Bezug auf T1 bzw. T2 ergibt sich ein weiches Ausschalten des vierten Transistors V4, sodaß die zeitliche Änderung des fließenden Stroms so klein ist, daß die Akkuspannung davon kaum beeinflußt wird.

Das Ausschalten des dritten Transistors V3 kann zeitlich parallel zum Ausschalten des vierten Transistors V4 erfogen. Vorzugsweise wird jedoch der dritte Transistor V3 erst dann ausgeschaltet, wenn nur noch ein geringer oder gar kein Strom mehr fließt, d.h. zeitversetzt zum Ausschalten des vierten Transistors V4. Das Ausschalten des dritten Transistors V3 kann nach demselben Verfahren erfolgen, wie es oben anhand des vierten Transistors V4 beschrieben wurde. Wenn allerdings nur noch ein geringer oder gar kein Strom mehr durch den dritten Transistor V3 fließt, kann dieser auch "hart" ausgeschaltet werden, indem die Steuerschaltung uC den zugehörigen Steueranschluß direkt von "High" auf "Low" umschaltet, ohne dadurch nennenswerte Störspannungen hervorzurufen. Durch das Ausschalten des dritten Transistors V3 wird der zweite Kondensator C2 aufgeladen.

Besonders vorteilhaft ist es jedoch, wenn nach dem Ausschalten des vierten Transistors V4 der erste Transistor V1 eingeschaltet wird, und der dritte Transistor V3 zunächst noch eingeschaltet bleibt, d.h. der Motor M über den ersten V1 und dritten Transistor V3 kurzgeschlossen wird, wie in der DE 102 46 520 A1 beschrieben ist. Der dann wegen der Induktivität des Motors M auch nach dem Abschalten des vierten Transistors V4 immer noch durch den Motor M fließende Kurzschlußstrom wird verbraucht, und kann nicht über die Schutzdioden des ersten V1 und zweiten Transistors V2 in den Akku fließen. Auf diese Weise wird der Wirkungsgrad der Schaltungsanordnung verbessert und verhindert, daß die parasitäre Induktivität des Akkumulators Störspannungen induziert. Erst wenn praktisch kein Strom mehr durch den Motor M fließt, wird der dritte Transistor V3 ausgeschaltet. Danach kann der zweite Transistor V2 eingeschaltet werden, indem die Steuerschaltung uC den zugehörigen Steueranschluß direkt von "High" auf "Low" umschaltet, sodaß jetzt über den ersten V1 und zweiten Transistor V2 ein Strom in umgekehrter Richtung durch den Motor M fließen kann, wobei wegen der Induktivität des Motors die zeitliche Änderung des Stroms beim Einschalten des zweiten Transistors V2 hinreichend klein ist.

In dem Fall, in dem das Einschalten des ersten V1 und zweiten Transistors V2 erst nach dem Ausschalten des dritten V3 und vierten Transistors V4 erfolgt, um einen Strom in umgekehrter Richtung durch den Motor M fließen zu lassen, wird vorzugsweise zuerst der erste Transistor V1 und danach der zweite Transistor V2 eingeschaltet, wobei der erste Transistor V1 auch "hart" eingeschaltet werden kann, indem die Steuerschaltung uC den zugehörigen Steueranschluß direkt von "Low" auf "High" umschaltet, ohne dadurch nennenswerte Störspannungen hervorzurufen. Durch das Einschalten des ersten Transistors V1 wird der erste Kondensator C1 entladen. Danach wird der zweite Transistor V2 eingeschaltet, was ebenfalls "hart" erfolgen kann, wenn der elektrische Verbraucher eine induktive Last darstellt.

Das Abschalten des durch den Motor M und den zweiten V2 und ersten Transistor V1 fließenden Stroms erfolgt so, wie schon oben anhand des Abschaltens des durch den vierten V4 und dritten Transistors V3 fließenden Stroms beschrieben wurde.

Somit erfolgt das Aus- und ggfs. Einschalten der elektronischen Schalter nach folgendem Verfahren: Die Steuerschaltung schaltet ihren Steueranschluß, der zum Steuern des elektronischen Schalters entweder als Eingang ("high impedance") oder als Ausgang ("Low" oder "High") geschaltet sein kann ("tristate"), in einem ersten Schritt von "Low" auf "high impedance" und erst in einem zweiten Schritt auf "High" bzw. in einem ersten Schritt von "High" auf "high impedance" und erst in einem zweiten Schritt auf "Low" um. Der zeitliche Abstand zwischen dem ersten Schritt und dem zweiten Schritt ist durch geeignete Dimensionierung einer mindestens einen Widerstand und einen Kondensator enthaltenden Beschaltung des elektronischen Schalters auf die Miller-Kapazität des elektronischen Schalters abgestimmt und vorzugsweise fest eingestellt, wobei die Beschaltung im Falle der oben beschriebenen Brückenschaltung aus den Widerständen Rp, Rg, R1, R2 und dem ersten C1 und zweiten Kondensator C2 gebildet ist.

## Patentansprüche

1. Schaltungsanordnung zum Ansteuern eines elektrischen Verbrauchers (M) mit einer Brückenschaltung, die vier elektronische Schalter (V1, V2, V3, V4) aufweist und in deren Querzweig der Verbraucher (M) angeordnet ist, und mit einer Steuerschaltung (uC), die Steueranschlüsse für die vier elektronischen Schalter aufweist,
**dadurch gekennzeichnet, daß**
der Steueranschluß für den ersten elektronischen Schalter (V1) über eine Reihenschaltung aus einem ersten Kondensator (C1) und einem ersten Widerstand (R1) mit dem Steueranschluß für den vierten elektronischen Schalter (V4) verbunden ist, und der Steueranschluß für den dritten elektronischen Schalter (V3) über eine Reihenschaltung aus einem zweiten Kondensator (C2) und einem zweiten Widerstand (R2) mit dem Steueranschluß für den zweiten elektronischen Schalter (V2) verbunden ist.

2. Schaltungsanordnung nach Anspruch 1,
**dadurch gekennzeichnet,**
**daß** die elektronischen Schalter (V1, V2, V3, V4) aus Transistoren, vorzugsweise aus MOS-Leistungstransistoren bestehen.

3. Schaltungsanordnung nach Anspruch 1 oder 2,
**dadurch gekennzeichnet,**
**daß** die Steuerschaltung (uC) aus einem Mikrokontroller, vorzugsweise einem Mikrokontroller in CMOS-Technik, besteht.

4. Schaltungsanordnung nach einem der vorhergehenden Ansprüche,
**dadurch gekennzeichnet,**
**daß** die Steueranschlüsse der Steuerschaltung (uC) als Eingang ("high impedance") oder als Ausgang ("Low" oder "High") geschaltet werden können ("tristate").

5. Schaltungsanordnung nach einem der vorhergehenden Ansprüche,
**dadurch gekennzeichnet,**
**daß** jeder Steueranschluß der Steuerschaltung (uC) mit dem Steueranschluß des zugehörigen elektronischen Schalters über einen Gate-Widerstand (Rg) verbunden ist.

6. Schaltungsanordnung nach einem der vorhergehenden Ansprüche 2 bis 5,
**dadurch gekennzeichnet,**
**daß** jeder Steueranschluß der Steuerschaltung (uC) mit dem Source-Anschluß des zugehörigen elektronischen Schalters über einen Pull-up- bzw. Pull-down-Widerstand (Rp) verbunden ist.

7. Elektrokleingerät mit einer Schaltungsanordnung nach einem der vorhergehenden Ansprüche.

8. Verfahren zum Schalten eines elektronischen Schalters mittels einer Steuerschaltung, die einen Steueranschluß zum Steuern des elektronischen Schalters aufweist, der entweder als Eingang in einem "high impedance"-Zustand oder als Ausgang in einem "Low"-Zustand oder einem "High"-Zustand geschaltet sein kann,
**dadurch gekennzeichnet, daß**
- eine Schaltungsanordnung zum Ansteuern eines elektrischen Verbrauchers (M) gemäß den Merkmalen das Anspruch 1 vorgesehen wird, und daß
- die Steuerschaltung zum Umschalten des elektronischen Schalters (V1, V2, V3, V4) vom leitenden Zustand in den nicht leitenden Zustand und/oder umgekehrt nacheinander zwei Schritte durchführt, nämlich bei dem Schalten von dem nicht leitenden Zustand in den leitenden Zustand den zugehörigen Steueranschluß der Steuerschaltung (uC) zunächst von dem "Low"-Zustand auf "high impedance"-Zustand und dann auf "High"-Zustand umschaltet und/oder bei dem Schalten von dem leitenden Zustand in den nicht leitenden Zustand zunächst von dem "High"-Zustand auf den "high impedance"-Zustand und dann auf "Low"-Zustand umschaltet.

9. Verfahren nach Anspruch 8,
**dadurch gekennzeichnet, daß**
die Steuerschaltung den zweiten Schritt, d.h. das Umschalten von dem "high impedance"-Zustand auf den "High"-Zustand oder den "Low"-Zustand, erst durchführt, nachdem der elektronische Schalter (V1, V2, V3, V4) seinen Zustand "leitend" bzw. "nicht leitend" geändert hat.

10. Verfahren nach Anspruch 8 oder 9,
**dadurch gekennzeichnet, daß**
der zeitliche Abstand zwischen dem ersten Schritt und dem zweiten Schritt durch geeignete Dimensionierung einer mindestens einen Widerstand (R1; R2; Rp) und einen Kondensator (C1; C2) enthaltenden Beschaltung des elektronischen Schalters (V1, V2, V3, V4) auf die Miller-Kapazität des elektronischen Schalters (V1, V2, V3, V4) abgestimmt ist.

11. Verfahren nach einem der vorhergehenden Ansprüche 8 bis 10,
**dadurch gekennzeichnet,**
**daß** mehrere elektronische Schalter (V1, V2, V3, V4) geschaltet werden, die eine Brückenschaltung bilden.

## Claims

1. Circuit arrangement for controlling an electrical consumer (M) with a bridge circuit which comprises four electronic switches (V1, V2, V3, V4) and in whose transversal leg the consumer (M) is arranged, and with a control circuit (uC) comprising the control terminal for the four electronic switches,
**characterized in that**
the control terminal for the first electronic switch (V1) is connected to the control terminal for the fourth electronic switch (V4) by means of a series connection comprising a first capacitor (C1) and a first resistor (R1), and the control terminal for the third electronic switch (V3) is connected to the control terminal for the second electronic switch (V2) by means of a series connection comprising a second capacitor (C2) and a second resistor (R2).

2. Circuit arrangement according to claim 1,
**characterized in that**
the electronic switches (V1, V2, V3, V4) comprise transistors, preferably MOS-type power transistors.

3. Circuit arrangement according to claim 1 or 2,
**characterized in that**
the control circuit (uC) comprises a microcontroller, preferably a microcontroller in CMOS technology.

4. Circuit arrangement according to one of the preceding claims,
**characterized in that**
the control terminals of the control circuit (uC) may be switched as an input ("high impedance") or as an output ("low" or "high") ("tri-state").

5. Circuit arrangement according to one of the preceding claims,
**characterized in that**
each control terminal of the control circuit (uC) is connected to the control terminal of the related electronic switch by means of a gate resistor (Rg).

6. Circuit arrangement according to one of the preceding claims 2 to 5,
**characterized in that**
each control terminal of the control circuit (uC) is connected to the source terminal of the related electronic switch by means of a pull-up or pull-down resistor (Rp).

7. Small electrical appliance having a circuit arrangement according to one of the preceding claims.

8. Method for switching an electronic switch by means of a control circuit comprising a control terminal for controlling the electronic switch which can either be switched as an input in a "high impedance" state or as an output in a "low" state or a "high" state,
**characterized in that**
- a circuit arrangement for controlling an electrical consumer (M) according to the features of claim 1 is provided and **that**
- the control circuit for switching the electronic switches (V1, V2, V3, V4) from the conducting state to the non-conducting state and/or vice versa carries out two steps in succession, namely when the non-conducting state is switched to the conducting state it switches the related control terminal of the control circuit (uC) initially from the "low" state to "high impedance" state and then to "high" state and/or when the conducting state is switched to the non-conducting state it switches initially from the "high" state to the "high impedance" state and then to "low" state.

9. Method according to claim 8,
**characterized in that**
the control circuit only carries out the second step, that is, the switching from the "high impedance" state to the "high" state or the "low" state after the electronic switch (V1, V2, V3, V4) has changed its state to "conducting" or "non-conducting".

10. Method according to claim 8 or 9,
**characterized in that**
the temporal interval between the first step and the second step is adjusted to the Miller capacitance of the electronic switch (V1, V2, V3, V4) by appropriate dimensioning of a circuit of the electronic switch (V1, V2, V3, V4) containing at least one resistor (R1; R2; Rp) and one capacitor (C1; C2).

11. Method according to one of the preceding claims 8 to 10,
**characterized in that**
a plurality of electronic switches (V1, V2, V3, V4) is switched which forms a bridge circuit.

## Revendications

1. Ensemble circuit pour commander un consommateur électrique (M), présentant un montage en pont, qui présente quatre commutateurs électroniques (V1, V2, V3, V4) et dans la branche transversale duquel est disposé le consommateur (M) et présentant un circuit de commande (uC), qui présente des bornes de commande pour les quatre commutateurs électroniques,
**caractérisé en ce que**
la borne de commande pour le premier commutateur électronique (V1) est connectée via un montage en série, formé d'un premier condensateur (C1) et d'une première résistance (R1), à la borne de commande pour le quatrième commutateur électronique (V4) et la borne de commande pour le troisième commutateur électronique (V3) est connectée via un montage en série, formé d'un deuxième condensateur (C2) et d'une deuxième résistance (R2), à la borne de commande pour le deuxième commutateur électronique (V2).

2. Ensemble circuit selon la revendication 1,
**caractérisé en ce que,**
les commutateurs électroniques (V1, V2, V3, V4) sont constitués par des transistors, de préférence des transistors de puissance MOS.

3. Ensemble circuit selon la revendication 1 ou 2,
**caractérisé en ce que,**
le circuit de commande (uC) est constitué par un microcontrôleur, de préférence un microcontrôleur dans la technique CMOS.

4. Ensemble circuit selon l'une quelconque des revendications précédentes,
**caractérisé en ce que,**
les bornes de commande du circuit de commande (uC) peuvent être commutées en tant qu'entrée (« high impédance » - haute impédance) ou en tant que sortie (« Low » - bas ou « High » - haut) (« Tri-Sate » - sortie à trois états).

5. Ensemble circuit selon l'une quelconque des revendications précédentes,
**caractérisé en ce que,**
chaque borne de commande du circuit de commande (uC) est connectée à la borne de commande du commutateur électronique associé via une résistance de grille (Rg).

6. Ensemble circuit selon l'une quelconque des revendications 2 à 5,
**caractérisé en ce que,**
chaque borne de commande du circuit de commande (uC) est connectée à la borne source du commutateur électronique associé via une résistance (Rp) de rappel à la source (« "pull-up »") ou une résistance de rappel à la masse (« pull-down »).

7. Petit appareil électrique présentant un ensemble circuit selon l'une quelconque des revendications précédentes.

8. Procédé pour commuter un commutateur électronique au moyen d'un circuit de commande, qui présente une borne de commande pour commander le commutateur électronique, qui peut être commuté, soit comme entrée dans un état « high impedance », soit comme sortie dans un état « low » ou dans un état « high »,
**caractérisé en ce que**
- un ensemble circuit pour la commande d'un consommateur électrique (M) selon les caractéristiques de la revendication 1 est utilisé et **en ce que**
- le circuit de commande pour commuter le commutateur électronique (V1, V2, V3, V4) d'un état conducteur dans un état non conducteur et/ou inversement effectue deux étapes l'une après l'autre, à savoir, lors de la commutation de l'état non conducteur dans l'état conducteur, la borne de commande associée du circuit de commande (uC) commute d'abord de l'état « low » dans l'état de « high impedance» et ensuite dans l'état « high » et/ou, lors de la commutation de l'état conducteur dans l'état non conducteur, d'abord de l'état « high »dans l'état de « high impedance » et ensuite dans l'état « low ».

9. Procédé selon la revendication 8,
**caractérisé en ce que**
le circuit de commande ne réalise la commutation de l'état de « high impedance » dans l'état « high » ou dans l'état « low » que lorsque le commutateur électronique(V1, V2, V3, V4) a modifié son état « conducteur » ou « non conducteur ».

10. Procédé selon la revendication 8 ou 9,
**caractérisé en ce que**
l'intervalle dans le temps entre la première étape et la seconde étape est adapté par un dimensionnement approprié d'une connexion contenant au moins une résistance (R1 ; R2 ; Rp) et un condensateur (C1 ; C2) du commutateur électronique (V1, V2, V3, V4) à la capacité de Miller du commutateur électronique (V1, V2, V3, V4)

11. Procédé selon l'une quelconque des revendications précédentes 8 à 10,
**caractérisé en ce que,**
plusieurs commutateurs électroniques (V1, V2, V3, V4) sont commutés, qui forment un montage en pont.
